# EUROPÄISCHE PATENTSCHRIFT

(11) **EP 2 710 644 B1**
(45) Veröffentlichungstag und Bekanntmachung des Hinweises auf die Patenterteilung: **14.02.2018**
(21) Anmeldenummer: 12715619.8
(22) Anmeldetag: 16.03.2012
(51) Int. Cl.: F21S 8/10, F21S 8/12, H01L 33/20, F21Y 115/10, F21Y 105/12

(54) **OPTOELEKTRONISCHES HALBLEITERMODUL UND DISPLAY MIT EINER MEHRZAHL DERARTIGER MODULE**
OPTOELECTRONIC SEMICONDUCTOR MODULE AND DISPLAY HAVING A PLURALITY OF SUCH MODULES
MODULE OPTOÉLECTRONIQUE À SEMI-CONDUCTEUR ET AFFICHAGE COMPRENANT UNE PLURALITÉ DE MODULES DE CE TYPE

(30) Priorität: 19.05.2011 DE 102011102032
(43) Veröffentlichungstag der Anmeldung: 26.03.2014
(73) Patentinhaber: OSRAM Opto Semiconductors GmbH, 93055 Regensburg (DE)
(72) Erfinder: VON MALM, Norwin, 93152 Nittendorf - Thumhausen (DE); BOGNER, Georg, 93138 Lappersdorf (DE); REILL, Joachim, 93197 Zeitlarn (DE); GRÖTSCH, Stefan, 93077 Lengfeld - Bad Abbach (DE)
(74) Vertreter: Epping - Hermann - Fischer
(86) Internationale Anmeldenummer: PCT/EP2012/054711
(87) Internationale Veröffentlichungsnummer: WO 2012/156121

(56) Entgegenhaltungen:
- EP-A1- 1 505 660
- EP-A2- 1 842 723
- WO-A1-2006/054616
- WO-A1-2007/115523
- US-A1- 2004 223 337
- US-A1- 2005 041 434

## Beschreibung

Die vorliegende Erfindung betrifft ein optoelektronisches Halbleitermodul mit einer Mehrzahl von im Betrieb lichtemittierenden Bereichen. Weiter betrifft die vorliegende Erfindung ein Display mit einer Mehrzahl von derartigen Halbleitermodulen.

Es ist oftmals erforderlich, die Abstrahlrichtung einer Lichtquelle, deren Licht in einem begrenzten Raumwinkelbereich gebündelt ist, wie zum Beispiel bei Scheinwerfern, während des Betriebs zu verändern. Das ist insbesondere bei Automobilscheinwerfern von Interesse. Hierbei sind drehbare Scheinwerferbefestigungen bekannt, die mit einer Steuerung mechanisch verbunden werden.

Als Autoscheinwerfer sind weiter adaptive Frontscheinwerfer bekannt, so genannte "adaptive Front Lighting Systems", kurz AFS. Derartige adaptive Frontscheinwerfer ermöglichen mehrere verschiedene Beleuchtungsaufgaben im Straßenverkehr in einem einzigen Lichtsystem. Insbesondere können damit verkehrssituationsabhängige Beleuchtungsszenarien erzeugt werden. Bei derartigen herkömmlichen, adaptiven Frontscheinwerfern tritt jedoch das Problem auf, dass es bei direkter Projektion der Leuchtdioden zur Abbildung der einzelnen Lichtquellen und zudem der dunklen Zwischenräume kommt, sodass keine homogene Ausleuchtung erreicht wird. Das ist insbesondere bei Autoscheinwerfern störend. Zudem ermöglichen herkömmliche adaptive Frontscheinwerfer keinen deutlich ausgeprägten Hell-Dunkel-Übergang, wie er unter anderem für das Abblendlicht vorgeschrieben ist.

Aus den Druckschriften DE 10 2005 014 754 A1, DE 10 2007 046 339 A1 und EP 1 842 723 A2 sind beispielsweise Kfz-Scheinwerfer bekannt, die mehrere einzelne LEDs oder LED-Chips umfassen, die separat angesteuert werden können, wobei in Kombination mit einer entsprechenden Optik dadurch ein variabler Scheinwerfer ermöglicht wird.

Aus der Druckschrift US 2005/0041434 A1 ist eine Lichtquelle für ein Fahrzeug bekannt, ebenso wie aus der Druckschrift EP 1 505 660 A1.

Die Druckschriften WO 2007/115523 A1 und US 2004/0223337 A1 betreffen jeweils Scheinwerfer für Kraftfahrzeuge.

Ein Licht emittierendes Bauteil, ein Licht emittierendes Modul, eine Displayhinterleuchtung und Herstellungsverfahren für diese Komponenten sind der Druckschrift WO 2006/054616 A1 zu entnehmen.

Es ist Aufgabe der vorliegenden Anmeldung, ein optoelektronisches Halbleitermodul mit veränderter Abstrahlcharakteristik anzugeben, das insbesondere für AFS geeignet ist, und mit dem ein deutlich ausgeprägter Hell-Dunkel-Übergang erzielt wird, wie er beispielsweise für das Abblendlicht vorgeschrieben ist.

Diese Aufgabe wird durch ein optoelektronisches Halbleitermodul mit den Merkmalen des Anspruchs 1 gelöst. Weiter wird diese Aufgabe durch ein Display mit einer Mehrzahl von derartigen Modulen nach Anspruch 8 gelöst. Vorteilhafte Weiterbildungen des Moduls und des Displays sind Gegenstand der abhängigen Ansprüche.

Es umfasst das optoelektronische Halbleitermodul eine Mehrzahl von im Betrieb lichtemittierenden Bereichen, wobei zumindest zwei aufeinander auftreffende Seitenkanten zumindest eines lichtemittierenden Bereichs zueinander in einem Winkel von mehr als 0° und weniger als 90° angeordnet sind.

Dieser zumindest eine lichtemittierende Bereich ist demnach nicht in Form eines Quadrats oder Rechtecks ausgebildet, sondern weist schräge Seitenkanten auf. Durch die schräge Ausbildung der Seitenkanten kann vorteilhafterweise die vorgeschriebene abgewinkelte Hell-Dunkel-Grenze des Abblendlichts mit besonders hohem Kontrast und geraden Kanten ausgebildet werden. Das erfindungsgemäße Modul ermöglicht somit eine Beleuchtung beispielsweise im Bereich der automobilen Frontbeleuchtung ohne mechanisch bewegbare Komponenten, die sich durch eine vorteilhafterweise hohe räumliche Auflösung mit gleichzeitig der erforderlichen Beleuchtungsstärke auszeichnet.

Die Mehrzahl von im Betrieb lichtemittierenden Bereichen können einstückig ausgebildet sein. In diesem Fall weisen die Mehrzahl von lichtemittierenden Bereichen einen gemeinsamen Halbleiterkörper mit einer aktiven Schicht auf, die zur Strahlungserzeugung geeignet ist. Dabei werden die lichtemittierenden Bereiche durch entsprechende Bestromung der Bereiche des Halbleiterkörpers gebildet.

Alternativ können die lichtemittierenden Bereiche separat und individuell ausgebildet sein. In diesem Fall weist jeder lichtemittierende Bereich einen separaten Halbleiterkörper mit einer aktiven Schicht zur Strahlungserzeugung auf.

Das Halbleitermodul weist vorzugsweise mindestens 2 x 2 lichtemittierende Bereiche auf, bevorzugt mindestens 10 x 10 lichtemittierende Bereiche, besonders bevorzugt mindestens 20 x 20 lichtemittierende Bereiche.

Die Seitenlängen der zumindest zwei aufeinander auftreffende Seitenkanten des zumindest einen lichtemittierenden Bereichs können gleich lang ausgebildet sein. Alternativ weisen die Seitenlängen der Seitenkanten unterschiedliche Längenverhältnisse auf.

In einer Abwandlung weisen alle lichtemittierenden Bereiche des Moduls zwei aufeinander auftreffende Seitenkanten auf, die zueinander in einem Winkel von mehr als 0° und weniger als 90° angeordnet sind. Demnach weisen alle lichtemittierenden Bereiche schräge Seitenkanten auf, die zum Ausbilden des besonders hohen Kontrastes und der geraden Kanten der Hell-Dunkel-Grenze geeignet sind.

In einer Weiterbildung sind die lichtemittierenden Bereiche des Moduls derart zueinander angeordnet, dass das Modul ebenfalls schräge Seitenkanten aufweist, also zumindest zwei aufeinander auftreffende Seitenkanten, die in einem Winkel von mehr als 0° und weniger als 90° zueinander angeordnet sind.

In einer Weiterbildung sind die lichtemittierenden Bereiche oberflächenemittierende Bereiche. Die lichtemittierenden Bereiche sind vorzugsweise zur Umwandlung von elektronisch erzeugten Daten oder Energien in Lichtemission oder umgekehrt geeignet. Die lichtemittierenden Bereiche sind insbesondere optoelektronische oder strahlungsemittierende Bereiche. Beispielsweise sind die lichtemittierenden Bereiche eine LED, besonders bevorzugt eine Dünnfilm-LED. Als Dünnfilm-LED wird im Rahmen der Anmeldung eine LED angesehen, während deren Herstellung das Aufwachssubstrat, auf dem der oder die Halbleiterkörper epitaktisch aufgewachsen wurde, vorzugsweise vollständig abgelöst ist.

Die lichtemittierenden Bereiche umfassen jeweils eine aktive Schicht oder einen Bereich einer aktiven Schicht, die vorzugsweise einen pn-Übergang, eine Doppelheterostruktur, eine Einfachquantentopfstruktur (SQW, single quantum well) oder eine Mehrfachquantentopfstruktur (MQW, multi quantum well) zur Strahlungserzeugung aufweist. Die lichtemittierenden Bereiche, insbesondere Schichten der lichtemittierenden Bereiche, enthalten vorzugsweise ein III/V-Halbleitermaterial. III/V-Halbleitermaterialien sind zur Strahlungserzeugung im ultravioletten über den sichtbaren bis in den infraroten Spektralbereich besonders geeignet. Vorzugsweise sind die lichtemittierenden Bereiche blau emittierende Bereiche.

Die lichtemittierenden Bereiche sind in Gruppen angeordnet, wobei die unterschiedlichen Gruppen der lichtemittierenden Bereiche eine unterschiedliche Ausgestaltung der zugehörigen lichtemittierenden Bereiche aufweisen. Es weist eine zweite Gruppe von lichtemittierenden Bereichen eine quadratische oder rechteckige Form auf, während eine erste Gruppe von lichtemittierenden Bereichen in Form eines Parallelogramms ausgebildet ist.

Es liegt der Winkel zwischen den zwei aufeinander auftreffenden Seitenkanten in der ersten Gruppe in einem Bereich zwischen einschließlich 15° und einschließlich 45°. Bei Seitenkanten mit einem Winkel in einem derartigen Bereich kann eine besonders gute Hell-Dunkel-Grenze mit besonders hohem Kontrast und geraden Kanten des Moduls gewährleistet werden.

Es sind die lichtemittierenden Bereiche der ersten Gruppe in Form eines Parallelogramms ausgebildet, vorzugsweise rautenförmig. Besonders bevorzugt sind die lichtemittierenden Bereiche des Moduls derart zueinander angeordnet, dass das Modul ebenfalls in Form eines Parallelogramms ausgebildet ist.

In einer Abwandlung ist der zumindest eine lichtemittierende Bereich in Form eines Dreiecks ausgebildet. In diesem Fall sind die Parallelogramme somit noch einmal mittig in zwei separate Bereiche unterteilt. In einer weiteren Abwandlung sind alle lichtemittierenden Bereiche des Moduls in Form eines Dreiecks ausgebildet. Besonders bevorzugt sind die dreieckförmigen, lichtemittierenden Bereiche derart zueinander angeordnet, dass das Modul insgesamt in Form eines Parallelogramms ausgebildet ist.

In einer Weiterbildung sind die lichtemittierenden Bereiche des Moduls matrixartig angeordnet. Matrixartig bedeutet dabei, dass die lichtemittierenden Bereiche in Zeilen und Spalten angeordnet sind und somit ein regelmäßiges Gitter bilden. Vorzugsweise weisen benachbarte lichtemittierende Bereiche dabei regelmäßige und gleiche Abstände zueinander auf.

Vorzugsweise können die lichtemittierenden Bereiche einer Spalte oder einer Zeile getrennt von den restlichen Zeilen beziehungsweise Spalten des Moduls elektronisch angesteuert werden. Dadurch ermöglicht sich vorteilhafterweise eine erweiterte Justage durch Ansteuerung der gewünschten Zeilen oder Spalten.

In einer Weiterbildung sind die lichtemittierenden Bereiche des Moduls gleichförmig in linearen Reihen, in alternierend ausgerichteten Reihen oder blockweise angeordnet. Die Anordnung in linearen Reihen ermöglicht beispielsweise die Formgebung des Moduls als Parallelogramm. Unter alternierend ausgerichteten Reihen sind insbesondere Reihen zu verstehen, die spiegelsymmetrisch zu einer Symmetrieachse ausgebildet sind. Unter einer blockweisen Anordnung ist insbesondere zu verstehen, dass die lichtemittierenden Bereiche in Gruppen angeordnet sind, wobei die unterschiedlichen Gruppen der lichtemittierenden Bereiche eine unterschiedliche Ausgestaltung der zugehörigen lichtemittierenden Bereiche aufweisen.

In einer Weiterbildung beträgt der Abstand zwischen zwei lichtemittierenden Bereichen zwischen einschließlich 1 µm und einschließlich 100 µm. Vorzugsweise beträgt der Abstand zweier lichtemittierender Bereiche zueinander weniger als 100 µm, bevorzugt weniger als 20 µm, besonders bevorzugt weniger als 10 µm.

In einer Weiterbildung weist zumindest eine Seitenkante jedes lichtemittierenden Bereichs eine Länge in einem Bereich zwischen einschließlich 30 µm und einschließlich 1 mm auf. Bevorzugt sind die Seitenlängen der lichtemittierenden Bereiche kleiner als 1 mm, bevorzugt kleiner als 300 µm, besonders bevorzugt kleiner als 150 µm.

In einer Weiterbildung ist den lichtemittierenden Bereichen in Abstrahlrichtung eine Primäroptik und/oder eine Sekundäroptik zur Veränderung der Abstrahlcharakteristik nachgeordnet. Dabei können den lichtemittierenden Bereichen eine gemeinsame Primäroptik und/oder gemeinsame Sekundäroptik nachgeordnet sein. Alternativ kann jeder lichtemittierende Bereich eine separate Primäroptik und/oder Sekundäroptik aufweisen. In diesem Fall können die lichtemittierenden Bereiche zueinander einen deutlich größeren Abstand als 100 µm aufweisen.

In einer Weiterbildung ist den lichtemittierenden Bereichen in Abstrahlrichtung eine Konversionsschicht nachgeordnet. Dabei kann die Konversionsschicht aus einer für alle lichtemittierenden Bereiche des Moduls gemeinsamen Schicht bestehen. Alternativ kann jeder lichtemittierender Bereich eine separate Konversionsschicht aufweisen. Als Materialien der Konversionsschicht finden Phosphorpartikel eingebettet in einer transparenten Matrix, wie beispielsweise einer Silikonmatrix, oder keramische Konverter Verwendung.

Vorzugsweise emittieren die lichtemittierenden Bereiche blaue Strahlung. Die Konversionsschicht ist bevorzugt geeignet, die blaue Strahlung in beispielsweise gelbe Strahlung zu konvertieren, sodass das Modul insgesamt Strahlung im weißen Farbortbereich emittiert.

Ein möglicher Verlauf der Lichtfarbe und Lichtintensität der von dem Modul emittierten Strahlung kann durch die Variation des Streugrades und/oder die geometrische Form der Konversionsschicht eingestellt werden.

Ein Übersprechen der von den einzelnen lichtemittierenden Bereichen emittierte Strahlung kann vorzugsweise dadurch vermieden werden, dass eine der Auskoppelseite gegenüberliegend angeordnete Spiegelschicht in einem Abstand zur aktiven Schicht des lichtemittierenden Bereichs derart eingestellt ist, dass eine von der aktiven Schicht in Richtung der Auskoppelseite emittierte Strahlung mit einer an der Spiegelschicht reflektierenden Strahlung derart interferiert, dass die lichtemittierenden Bereiche eine Abstrahlcharakteristik der emittierten Strahlung mit einer Vorzugsrichtung in Vorwärtsrichtung aufweisen. Ferner kann ein Übersprechen auch durch absorbierende oder reflektierende Stege zwischen den lichtemittierenden Bereichen vermieden werden.

Es sind die Gruppen von lichtemittierenden Bereichen jeweils unabhängig voneinander bestrombar. Hierzu ist beispielsweise jeder lichtemittierende Bereich eineindeutig einem Transistor einer Aktivmatrixansteuerung zugeordnet.

In einer Ausführungsform weist ein Display eine Mehrzahl von optoelektronischen Halbleitermodulen auf, die lateral nebeneinander angeordnet sind. So kann beispielsweise ein Display erzielt werden, das als Kfz-Scheinwerfer Verwendung findet. Die einzelnen Module des Displays können dabei direkt nebeneinander angeordnet sein, sodass eine regelmäßige Matrix der lichtemittierenden Bereiche über alle Module entsteht. Alternativ können die Module des Displays beliebig verteilt sein, also in einem unterschiedlichen Abstand zueinander angeordnet sein. Dadurch ergeben sich mit Vorteil eine kleine dezentrale Abbildungsoptik und damit die Möglichkeit eines sehr flachen Scheinwerferdesigns. Eine den Modulen nachgeordnete Projektionsoptik setzt dabei vorzugsweise die einzelnen Beiträge der von den Modulen emittierten Strahlung zu einer zusammenhängenden Lichtmatrix zusammen.

Die in Verbindung mit dem Modul angeführten Merkmale finden auch in Zusammenhang mit dem Display Verwendung und umgekehrt.

In einer Weiterbildung sind die zu einem Modul gehörenden lichtemittierenden Bereiche jeweils unabhängig von den lichtemittierenden Bereichen benachbarter Module betreibbar. Beispielsweise sind die Module des Displays mit einer Aktivmatrixansteuerung verbunden und dadurch separat voneinander bestrombar. Vorzugsweise sind bereits die lichtemittierenden Bereiche eines Moduls jeweils unabhängig voneinander bestrombar, indem beispielsweise jeder lichtemittierende Bereich eineindeutig einem Transistor der Aktivmatrixansteuerung zugeordnet ist.

Vorzugsweise umfasst das Display zumindest eine Ansteuerschaltung zum Betreiben der lichtemittierenden Bereiche zumindest eines Moduls. Beispielsweise wird das Display mit den optoelektronischen Modulen durch elektronische Bauelemente erweitert, die beispielsweise eine Umsetzung eines codierten Signals von extern in ein Schaltmuster der Anordnung, wie beispielsweise Zeilen und Spalten, der lichtemittierenden Bereiche übersetzt. Hierbei sind beispielsweise Eingangssignale eines CAN-Bus oder einer I²C-Schnittstelle zu berücksichtigen. Die elektronischen Bauelemente und Steuerelemente können dabei monolithisch integriert mit den Modulen ausgebildet oder als diskretes Bauteil ausgeführt sein.

Die Aktivmatrixansteuerung des Displays weist vorzugsweise Transistoren in Form einer in Si realisierten CMOS-Struktur auf, mit der die lichtemittierenden Bereiche der Module verbunden sind. Dies kann beispielsweise durch Direktbonden der Halbleiterschichten der lichtemittierenden Bereiche und des Si-Wafers erfolgen oder durch gleichzeitigen und sequentiellen Transfer der Schichten der lichtemittierenden Bereiche auf Montageflächen des Si-Wafers. Alternativ kann auch ein Aufwachssubstrat der lichtemittierenden Bereiche als Substrat zur Abscheidung und Strukturierung von beispielsweise Dünnfilm-Transistoren genutzt werden.

In einer Weiterbildung weist das Display weitere Bauelemente wie beispielsweise Lichtsensoren, Farbsensoren oder Temperatursensoren auf, die in oder an die Module integriert sind.

In einer Ausführungsform finden die Displays mit einer Mehrzahl von Modulen Verwendung als Autoscheinwerfer, der je nach Ansteuerung der lichtemittierenden Bereiche unterschiedliche Lichtfunktionen erfüllt. Als Lichtfunktionen kommen beispielsweise adaptives blendfreies Fern- und Abblendlicht für Stadt, Landstraße und Autobahn, Tagfahrlicht, Positionslicht, Spotlicht, Kurvenlicht, Abbiegelicht, automatische Leuchtweitenregulierung und fahrerabhängiges Design des Autoscheinwerfers in Frage.

Weitere Vorteile und vorteilhafte Weiterbildungen der Erfindung ergeben sich aus den im Folgenden in Verbindung mit den Figuren 1 bis 4 beschriebenen Ausführungsbeispielen. Es zeigen:

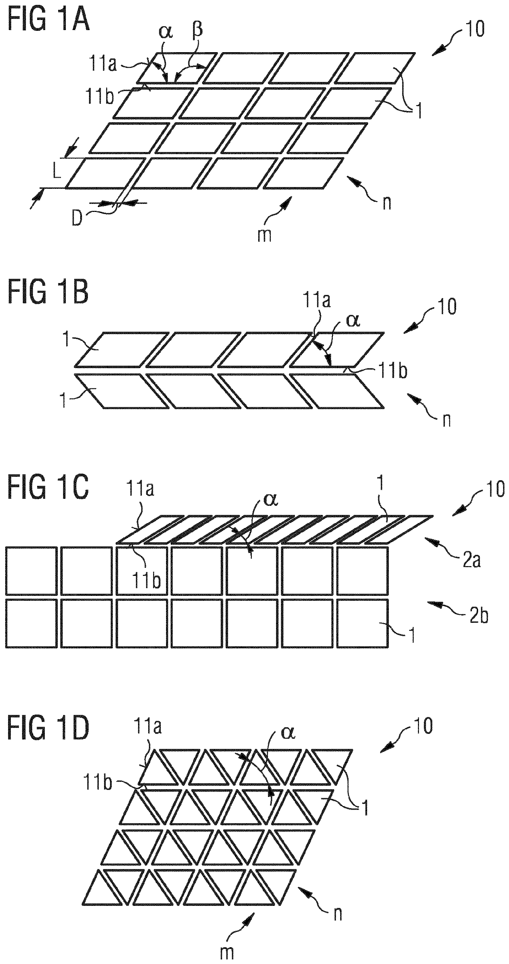

Figur 1C eine schematische Ansicht eines Ausführungsbeispiels eines erfindungsgemäßen Moduls,
Figuren 1A, 1B und 1D jeweils eine schematische Ansicht einer Abwandlung eines nicht erfindungsgemäßen Moduls,
Figuren 2A und 2B jeweils eine schematische Ansicht einer Abwandlung eines nicht erfindungsgemäßen Displays, und
Figuren 3 und 4 jeweils eine schematische Ansicht eines Ausführungsbeispiels eines erfindungsgemäßen Displays.

In den Figuren können gleiche oder gleich wirkende Bestandteile jeweils mit den gleichen Bezugszeichen versehen sein. Die dargestellten Bestandteile und deren Größenverhältnisse untereinander sind nicht als maßstabsgerecht anzusehen. Vielmehr können einzelne Bestandteile, wie beispielsweise Schichten, Strukturen, Komponenten und Bereiche zur besseren Darstellbarkeit und/oder zum besseren Verständnis übertrieben dick oder groß dimensioniert dargestellt sein.

In Figur 1A ist eine Aufsicht auf eine Abwandlung eines optoelektronischen Halbleitermoduls 10 gezeigt, das eine Mehrzahl im Betrieb lichtemittierende Bereiche umfasst. Die lichtemittierenden Bereiche 1 sind dabei matrixartig angeordnet, beispielsweise auf einem Träger. Das bedeutet, dass die lichtemittierenden Bereiche 1 in Zeilen n und Spalten m angeordnet sind, sodass die Anordnung der lichtemittierenden Bereiche 1 gitterartig ausgeführt ist. Die lichtemittierenden Bereiche 1 weisen dabei eine identische Größe auf und sind in regelmäßigen und gleichen Abständen zueinander angeordnet. Der Abstand D zwischen den lichtemittierenden Bereichen 1 beträgt zwischen einschließlich 1 µm und einschließlich 100 µm, vorzugsweise ≤ 100 µm, besonders bevorzugt ≤ 20 µm, vorzugsweise ≤ 10 µm.

Das Modul der Figur 1A weist eine Matrix aus 4 x 4 lichtemittierenden Bereichen auf. Das Modul kann jedoch auch eine davon abweichende Anzahl an lichtemittierenden Bereichen aufweisen. Beispielsweise weist das Modul mindestens 20 x 20 lichtemittierende Bereiche, bevorzugt mindestens 10 x 10 lichtemittierende Bereiche auf.

Die lichtemittierenden Bereiche 1 des Moduls der Figur 1A weisen aufeinander auftreffende Seitenkanten auf, die alle in einem Winkel angeordnet sind, der von 90° abweicht. Insbesondere sind die lichtemittierenden Bereiche 1 jeweils in Form eines Parallelogramms ausgebildet. Das Parallelogramm ist dabei jeweils aufgrund der Abweichung des Winkels von 90° nicht als Rechteck oder Quadrat ausgebildet. Das heißt, dass keine der Seitenkanten der lichtemittierenden Bereiche in einem Winkel von 90°, also senkrecht zueinander, stehen. Das Parallelogramm weist dabei einen kleinen Winkel α und im benachbarten Eck einen weiteren Winkel β auf. Der kleinere Winkel α liegt vorzugsweise in einem Bereich zwischen einschließlich 15° und einschließlich 45°. Derartig ausgebildete lichtemittierende Bereiche sind insbesondere geeignet zur Gewährleistung der vorgesehenen Hell-Dunkel-Grenze eines Abblendlichts von einem Autoscheinwerfer, wobei die Hell-Dunkel-Grenze dabei vorteilhafterweise einen hohen Kontrast und gerade Kanten ausbildet. Damit können ohne mechanisch bewegliche Komponenten verschiedene Scheinwerferfunktionen mit unterschiedlichen Beleuchtungen in einem einzigen Modul erzielt werden, wobei gleichzeitig eine hohe räumliche Auflösung und eine hohe Beleuchtungsstärke erzeugt wird.

Die lichtemittierenden Bereiche 1 sind derart in Zeilen n und Spalten m angeordnet, dass sich eine regelmäßige gleichförmige, in linearen Reihen und linearen Spalten eingeteilte Anordnung der lichtemittierenden Bereiche 1 ergibt.

Die lichtemittierenden Bereiche 1 sind zusätzlich derart zueinander angeordnet, dass das Modul 10 insgesamt ebenfalls ein Parallelogramm ausbildet, bei dem zwei aufeinander auftreffende Seitenkanten schräg zueinander ausgebildet sind, also ebenfalls den Winkel α aufweisen, der mehr als 0° und weniger als 90° ist.

Die Seitenkanten 11a jedes lichtemittierenden Bereichs 1 weist eine Länge L in einem Bereich zwischen einschließlich 30 µm und einschließlich 1 mm auf. Vorzugsweise sind die Seitenlängen ≤ 1 mm, bevorzugt ≤ 300 µm, besonders bevorzugt ≤ 150 µm. Die Seitenkanten der lichtemittierenden Bereiche können dabei unterschiedliche Längenverhältnisse aufweisen.

Die lichtemittierenden Bereiche 1 sind aus Halbleitermaterial gebildet. Vorzugsweise sind die lichtemittierenden Bereiche 1 aus einem Halbleiterkörper gebildet, der eine zur Strahlungserzeugung vorgesehene und geeignete aktive Schicht aufweist. Dabei können die einzelnen lichtemittierenden Bereiche 1 eines Moduls 10 einen gemeinsamen Halbleiterkörper oder separat voneinander benachbart angeordnete Halbleiterkörper aufweisen.

Beispielsweise sind die lichtemittierenden Bereiche jeweils eine LED, die vorzugsweise Strahlung im blauen Wellenlängenbereich emittiert.

Im Unterschied zu der Abwandlung der Figur 1A sind die lichtemittierenden Bereiche 1 der Abwandlung der Figur 1B in alternierend ausgerichteten Reihen n zueinander angeordnet. Das bedeutet, dass die lichtemittierenden Bereiche 1 spiegelsymmetrisch zu einer Symmetrieachse angeordnet sind. Alle lichtemittierenden Bereiche 1 des Moduls 10 gemäß dem Ausführungsbeispiel der Figur 1B weisen dabei wiederum jeweils schräg zueinander stehende Seitenkanten 11a, 11b auf, die einen Winkel α miteinander einschließen, der mehr als 0° und weniger als 90° beträgt.

Das Modul des Ausführungsbeispiels der Figur 1C unterscheidet sich von dem Modul der Figur 1A dadurch, dass die lichtemittierenden Bereiche 1 blockweise angeordnet sind. Das bedeutet, dass die lichtemittierenden Bereiche 1 in zwei Gruppen 2a, 2b eingeteilt werden können, wobei alle lichtemittierenden Bereiche einer Gruppe gleich zueinander ausgebildet sind. Beispielsweise sind die lichtemittierenden Bereiche 1 der ersten Gruppe 2a in Form eines Parallelogramms ausgebildet, das schräg zueinander stehende Seitenkanten 11a, 11b aufweist, die einen Winkel α von mehr als 0° und weniger als 90° einschließen. Die lichtemittierenden Bereiche 1 der zweiten Gruppe 2b sind in Form eines Rechtecks oder eines Quadrats ausgebildet. Diese lichtemittierenden Bereiche 1 weisen somit Seitenkanten auf, die senkrecht zueinander stehen.

Die in Figur 1D dargestellte Abwandlung eines Moduls 10 weist im Unterschied zu der Abwandlung des Moduls der Figur 1A mittig geteilte in Parallelogrammform vorliegende lichtemittierende Bereiche auf. Die lichtemittierenden Bereiche 1 des Moduls 10 der Figur 1D sind somit als Dreieck ausgebildet. Die als Dreieck ausgebildeten lichtemittierenden Bereiche weisen dabei wiederum zwei Seitenkanten 11a und 11b auf, die einen Winkel α miteinander einschließen, der von 90° abweicht. Der Winkel α beträgt dabei bevorzugt 45° oder 15°. Die lichtemittierenden Bereiche 1 sind wiederum in Zeilen n und Spalten m eingeteilt und bilden so ein matrizenartiges Gitter aus.

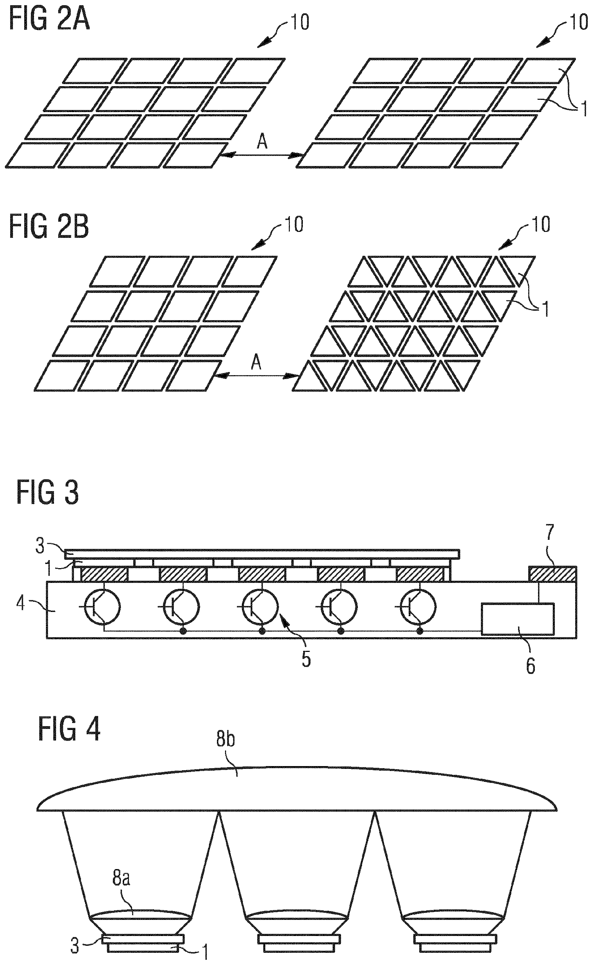

In Figur 2 ist ein Display gezeigt, das eine Mehrzahl von optoelektronischen Halbleitermodulen 10 umfasst, die lateral nebeneinander angeordnet sind. Die Module 10 des Displays der Figur 2A entsprechen dem Modul der Abwandlung der Figur 1A.

Die Module 10 sind dabei in einem Abstand A zueinander angeordnet. Alternativ können die Module 10 direkt nebeneinander derart angeordnet sein, dass eine regelmäßige Matrix der lichtemittierenden Bereiche über alle Module entsteht (nicht dargestellt).

Die Anzahl der Module 10 des Displays kann dabei von der Darstellung der Figur 2A abweichen. Insbesondere können mehr als zwei Module 10 ein Display bilden.

Die zu einem Modul 10 gehörenden lichtemittierenden Bereiche 1 sind vorzugsweise jeweils unabhängig von den lichtemittierenden Bereichen benachbarter Module betreibbar. Hierzu findet beispielsweise eine Ansteuerschaltung Verwendung. Beispielsweise werden das Display und die dazugehörigen Module mit einer Aktivmatrixansteuerung bestromt. Hierzu ist beispielsweise jeder lichtemittierende Bereich eineindeutig einem Transistor der Aktivmatrixansteuerung zugeordnet, womit die lichtemittierenden Bereiche unabhängig voneinander bestromt werden können. Eine derartige Aktivmatrixansteuerung ist in Zusammenhang mit dem Ausführungsbeispiel der Figur 3 näher erörtert.

Die Abwandlung der Figur 2B unterscheidet sich von der Abwandlung der Figur 2A dadurch, dass unterschiedlich ausgestaltete Module 10 für das Display Verwendung finden. Eines der Module 10 ist beispielsweise entsprechend dem Modul der Figur 1A ausgebildet, während das zweite Modul 10 einem Modul gemäß der Figur 1D entspricht. Je nach gewünschter Abstrahlcharakteristik können somit mehrere unterschiedliche Module zu einem Display kombiniert werden. Die Kombination unterschiedlicher Module 10 ist dabei beispielsweise abhängig von der gewünschten Lichtfunktion des Displays. Als Lichtfunktion kommt unter anderem ein adaptives blendfreies Fern- und Abblendlicht für Stadt, Landstraße und Autobahn, ein Tagfahrlicht, ein Positionslicht, ein Spotlicht, ein Kurvenlicht, ein Abbiegelicht, eine automatische Leuchtweitenregulierung und fahrerabhängiges Design des Scheinwerferlichts in Frage.

In Figur 3 ist ein Querschnitt eines erfindungsgemäßen Displays gezeigt, das zumindest ein Modul mit lichtemittierenden Bereichen umfasst, die auf einer Aktivmatrixansteuerung 4, 5, 6, 7 angeordnet sind. Das Display ist im Vergleich zu den Abwandlungen der Figuren 2A und 2B also durch elektronische Bauelemente erweitert, die beispielsweise die Umsetzung eines codierten Signals von extern in ein Schaltmuster der Zeilen und Spalten der Module übersetzt. Beispielsweise sind dabei Eingangssignale eines CAN-Bus oder einer I²C-Schnittstelle zu berücksichtigen. Die elektronischen Steuerelemente können dabei monolithisch integriert oder als diskrete Bauteile ausgeführt sein.

Die Aktivmatrixansteuerung weist beispielsweise Transistoren 5 auf, die in Form einer in Si realisierten CMOS-Struktur vorliegen, mit der die lichtemittierenden Bereiche des Moduls eineindeutig elektrisch und mechanisch verbunden sind. Dies kann beispielsweise durch Direktbonden der lichtemittierenden Bereiche und Transistoren realisiert werden. Alternativ können die lichtemittierenden Bereiche sequentiell oder gleichzeitig auf Montageflächen des Si-Wafers der Transistoren montiert werden. Alternativ kann auch ein Aufwachssubstrat, das zum Aufwachsen der Schichten der lichtemittierenden Bereiche 1 Verwendung findet, als Substrat zur Abscheidung und Strukturierung der Dünnfilmtransistoren 5 genutzt werden.

Die Aktivmatrix der Figur 3 weist neben den Transistoren 5 die Aktivmatrix 4 aus Si, einen Mikrocontroller 6 und einen Anschlussbereich 7 auf.

Auf den lichtemittierenden Bereichen, insbesondere auf einer Strahlungsaustrittsseite der lichtemittierenden Bereichen 1, ist eine Konversionsschicht 3 angeordnet. Die Konversionsschicht 3 ist den lichtemittierenden Bereichen 1 demnach in Abstrahlrichtung nachgeordnet. Die Konversionsschicht 3 weist beispielsweise Phosphorpartikel eingebettet in einer transparenten Matrix, wie beispielsweise Silikon, oder keramische Konverter auf. Vorzugsweise emittieren die lichtemittierenden Bereiche 1 blaue Strahlung, die von der Konversionsschicht 3 in gelbe Strahlung umgewandelt wird, sodass insgesamt das Display weißes Licht emittiert.

Im Ausführungsbeispiel der Figur 3 ist allen lichtemittierenden Bereichen eines Moduls die Konversionsschicht 3 als gemeinsame Schicht nachgeordnet.

In dem Display des Ausführungsbeispiels der Figur 3 können zusätzlich weitere elektronische Bauelemente integriert sein (nicht dargestellt), wie beispielsweise Lichtsensoren, Farbsensoren oder Temperatursensoren.

In dem Ausführungsbeispiel der Figur 4 ist ein weiteres Display gezeigt, bei dem im Unterschied zu dem in Figur 3 dargestellten Display den lichtemittierenden Bereichen 1 eine Primäroptik 8a und eine Sekundäroptik 8b in Abstrahlrichtung nachgeordnet ist. Die Primäroptik 8a beeinflusst dabei die von den lichtemittierenden Bereichen 1 emittierte Strahlung in einer vorbestimmten Art und Weise. Jedem lichtemittierenden Bereich 1 ist eine separate Primäroptik 8a nachgeordnet. Den Primäroptiken 8a ist weiter die Sekundäroptik 8b in Abstrahlrichtung nachgeordnet, wobei die Sekundärstrahlung 8b für alle lichtemittierenden Bereiche gemeinsam ist. Zwischen den Primäroptiken 8a und der Sekundäroptik 8b ist in Figur 4 mittels Linien die Lichtemission der einzelnen lichtemittierenden Bereiche 1 gezeigt.

Im Unterschied zum Ausführungsbeispiel der Figur 3 weist die Konversionsschicht 3 des Ausführungsbeispiels der Figur 4 separate Bereiche auf. Beispielsweise ist jedem separaten lichtemittierenden Bereich 1 genau eine Konversionsschicht nachgeordnet, wobei die Konversionsschichten der einzelnen lichtemittierenden Bereiche räumlich und mechanisch voneinander getrennt sind.

Durch die Kopplung der von den lichtemittierenden Bereichen 1 emittierten Strahlung mittels der Primäroptiken 8a und der Sekundäroptik 8b können die lichtemittierenden Bereiche 1 in einem großen Abstand zueinander angeordnet sein, insbesondere in einem Abstand zueinander, der größer als 100 µm ist. Die Sekundäroptik 8b ist dabei vorzugsweise geeignet, die einzelnen Beiträge der lichtemittierenden Bereiche zu einer zusammenhängenden Lichtmatrix zusammenzufassen.

## Patentansprüche

1. Strahlungsemittierendes Halbleiter-Modul (10) umfassend eine Mehrzahl von im Betrieb lichtemittierenden Bereichen (1), wobei zumindest zwei aufeinander auftreffende Seitenkanten (11a, 11b) zumindest eines lichtemittierenden Bereichs (1) in einem Winkel (α) von mehr als 0° und weniger als 90° zueinander angeordnet sind, **dadurch gekennzeichnet, dass** die lichtemittierenden Bereiche (1) in zwei Gruppen (2a, 2b) eingeteilt sind und alle lichtemittierenden Bereiche (1) innerhalb der Gruppen (2a, 2b) gleich zueinander ausgebildet sind,
wobei die lichtemittierenden Bereiche (1) der ersten Gruppe (2a) in Form eines Parallelogramms ausgebildet sind und der Winkel (α) in einem Bereich zwischen einschließlich 15° und einschließlich 45° liegt,
wobei die lichtemittierenden Bereiche (1) der zweiten Gruppe (2b) in Form eines Rechtecks oder eines Quadrats ausgebildet sind, und
wobei die Gruppen (2a, 2b) lateral nebeneinander angeordnet und unabhängig voneinander bestrombar sind.

2. Modul nach dem vorhergehenden Anspruch, wobei die lichtemittierenden Bereiche (1) matrixartig angeordnet sind.

3. Modul nach einem der vorhergehenden Ansprüche, wobei die lichtemittierenden Bereiche (1) gleichförmig in linearen Reihen (n), in alternierend ausgerichteten Reihen (n) oder blockweise (2a, 2b) angeordnet sind.

4. Modul nach einem der vorhergehenden Ansprüche, wobei der Abstand (D) zwischen zwei lichtemittierenden Bereichen (1) zwischen einschließlich 1 µm und einschließlich 100 µm beträgt.

5. Modul nach einem der vorhergehenden Ansprüche, wobei zumindest eine Seitenkante (11a) jedes lichtemittierenden Bereichs (1) eine Länge (L) in einem Bereich zwischen einschließlich 30 µm und einschließlich 1 mm aufweist.

6. Modul nach einem der vorhergehenden Ansprüche, wobei den lichtemittierenden Bereichen (1) in Abstrahlrichtung eine Primäroptik (8a) und/oder eine Sekundäroptik (8b) nachgeordnet ist.

7. Modul nach einem der vorhergehenden Ansprüche, wobei den lichtemittierenden Bereichen (1) in Abstrahlrichtung eine Konversionsschicht (3) nachgeordnet ist.

8. Display mit einer Mehrzahl von optoelektronischen Halbleiter-Modulen (10) nach einem der vorhergehenden Ansprüche, die lateral nebeneinander angeordnet sind, weiter umfassend:
zumindest eine Ansteuerschaltung (4, 5, 6, 7) zum Betreiben der lichtemittierenden Bereiche (1) zumindest eines Moduls (10).

9. Verwendung eines Displays nach dem vorhergehenden Anspruch als Autoscheinwerfer, der je nach Ansteuerung der lichtemittierenden Bereiche (1) unterschiedliche Lichtfunktionen erfüllt.

## Claims

1. Radiation-emitting semiconductor module (10) comprising a plurality of - during operation - light-emitting regions (1), wherein at least two mutually abutting lateral edges (11a, 11b) of at least one light-emitting region (1) are arranged at an angle (α) of more than 0° and less than 90° with respect to one another,
**characterized in that**
the light-emitting regions (1) are divided into two groups (2a, 2b) and all light-emitting regions (1) within the groups (2a, 2b) are embodied identically to one another,
wherein the light-emitting regions (1) of the first group (2a) are embodied in the form of a parallelogram and the angle (α) is in a range of between 15° and 45° inclusive, wherein the light-emitting regions (1) of the second group (2b) are embodied in the form of a rectangle or a square, and wherein the groups (2a, 2b) are arranged laterally alongside one another and can be energized independently of one another.

2. The module according to the preceding claim,
wherein the light-emitting regions (1) are arranged in a matrix-like fashion.

3. The module according to any of the preceding claims, wherein the light-emitting regions (1) are arranged uniformly in linear series (n), in alternately oriented series (n) or in a blockwise fashion (2a, 2b).

4. The module according to any of the preceding claims, wherein the distance (D) between two light-emitting regions (1) is between 1 µm and 100 µm inclusive.

5. The module according to any of the preceding claims, wherein at least one lateral edge (11a) of each light-emitting region (1) has a length (L) in a range of between 30 µm and 1 mm inclusive.

6. The module according to any of the preceding claims, wherein a primary optical unit (8a) and/or a secondary optical unit (8b) are/is disposed downstream of the light-emitting regions (1) in the emission direction.

7. The module according to any of the preceding claims, wherein a conversion layer (3) is disposed downstream of the light-emitting regions (1) in the emission direction.

8. display having a plurality of optoelectronic semiconductor modules (10) according to any of the preceding claims, which are arranged laterally alongside one another, further comprising:
at least one drive circuit (4, 5, 6, 7) for operating the light-emitting regions (1) of at least one module (10).

9. The use of a display according to the preceding claim as an automobile headlight which fulfills different light functions depending on the driving of the light-emitting regions (1).

## Revendications

1. Module semi-conducteur (10) émettant un rayonnement, comprenant une pluralité de zones (1) émettant de la lumière pendant leur fonctionnement, au moins deux arêtes latérales (11a, 11b) se rencontrant l'une avec l'autre d'au moins une zone (1) émettant de la lumière étant disposées dans un angle (α) supérieur à 0° et inférieur à 90° l'une par rapport à l'autre,
**caractérisé en ce que**
les zones (1) émettant de la lumière sont réparties en deux groupes (2a, 2b), et **en ce que** toutes les zones (1) émettant de la lumière sont conçues de manière identique les unes par rapport aux autres au sein des groupes (2a, 2b),
les zones (1) émettant de la lumière du premier groupe (2a) étant conçues sous forme d'un parallélogramme, et l'angle (α) étant situé dans une plage comprise entre, y compris, 15° et, y compris, 45°, les zones (1) émettant de la lumière du deuxième groupe (2b) étant conçues sous forme d'un rectangle ou d'un carré, et
les groupes (2a, 2b) étant disposés latéralement l'un à côté de l'autre et pouvant être alimentés en courant indépendamment l'un de l'autre.

2. Module selon la revendication précédente,
les zones (1) émettant de la lumière étant disposées de manière matricielle.

3. Module selon l'une quelconque des revendications précédentes, les zones (1) émettant de la lumière étant disposées de manière uniforme en rangées (n) linéaires, en rangées (n) orientées de manière alternante ou par blocs (2a, 2b).

4. Module selon l'une quelconque des revendications précédentes, l'écart (D) entre deux zones (1) émettant de la lumière étant compris entre, y compris, 1 µm et, y compris, 100 µm.

5. Module selon l'une quelconque des revendications précédentes, au moins une arête latérale (11a) de chaque zone (1) émettant de la lumière présentant une longueur (L) située dans une plage comprise entre, y compris, 30 µm et, y compris, 1 mm.

6. Module selon l'une quelconque des revendications précédentes, une optique primaire (8a) et/ou une optique secondaire (8b) étant disposées en aval des zones (1) émettant de la lumière, en direction de rayonnement.

7. Module selon l'une quelconque des revendications précédentes, une couche de conversion (3) étant disposée en aval des zones (1) émettant de la lumière, en direction de rayonnement.

8. Écran comprenant une pluralité de modules semi-conducteurs (10) optoélectroniques selon l'une quelconque des revendications précédentes, lesquels sont disposés latéralement les uns à côté des autres, comprenant en outre :
au moins un circuit de commande (4, 5, 6, 7) destiné au fonctionnement des zones (1) émettant de la lumière d'au moins un module (10).

9. Utilisation d'un écran selon la revendication précédente en tant que phare de voiture qui remplit différentes fonctions lumineuses après la commande des zones (1) émettant de la lumière.
